# EUROPEAN PATENT SPECIFICATION

(11) **EP 2 986 098 B1**
(45) Date of publication and mention of the grant of the patent: **23.05.2018**
(21) Application number: 13881710.1
(22) Date of filing: 11.04.2013
(51) Int. Cl.: H05K 13/02, B65H 19/18, B65H 21/00

(54) **SPLICING DEVICE**
SPLEISSVORRICHTUNG
DISPOSITIF D'ÉPISSURAGE

(43) Date of publication of application: 17.02.2016
(73) Proprietor: Fuji Machine Mfg. Co., Ltd., Chiryu-shi, Aichi 472-8686 (JP)
(72) Inventor: CHI Xiao Dong, Chiryu-shi Aichi 472-8686 (JP)
(74) Representative: Grünecker Patent- und Rechtsanwälte PartG mbB
(86) International application number: PCT/JP2013/060964
(87) International publication number: WO 2014/167692

(56) References cited:
- EP-A1- 0 613 339
- JP-A- H0 964 109
- JP-A- 2002 207 286
- JP-A- 2010 120 344
- JP-A- 2011 233 600
- JP-U- S62 153 246

## Description

### Technical Field

The invention relates to a splicing device which automatically connects two carrier tapes, and particularly to a splicing device which accurately takes out a carrier tape in which splicing has been completed from the inside of a device.

### Background Art

In a general component mounting machine, as a carrier tape which holds a plurality of electronic components at a constant interval is wound around a reel, and a sprocket that is engaged with a feeding hole punched on the carrier tape is driven, the carrier tape is fed out by a fixed amount, the electronic components are supplied to a component supply position sequentially, and the electronic components are suctioned by a suction nozzle and are mounted on a circuit board.

In this type of component mounting machine, when a residual amount of electronic components which are held by one reel decreases, connecting a leader of the carrier tape wound around a separate reel which holds the same type of electronic component to a trailer of the carrier tape in which the residual amount thereof is small by a splicing tape, that is, so-called splicing is performed. A device which has such a splicing function is described, for example, in PTL 1.
Another device is disclosed in the document P 2002- 207286.

### Citation List

### Patent Literature

PTL 1: JP-A-2007-335595

### Summary of Invention

### Technical Problem

However, in recent years, an attempt to automatically perform the splicing has been made, but in order to automatically perform the splicing, it is necessary to automatically transport the splicing tape to a splicing position. For this purpose, it is effective to paste one surface side of a plurality of splicing tapes having both surfaces as adhesive surfaces to a protective tape, to position the splicing tape to the splicing position by feeding the protective tape, and to adhere the other surface side of the splicing tape to the carrier tape at the splicing position.

In this case, since the splicing tape is in a state of being affixed to the protective tape, when taking out the carrier tape which is connected by the splicing tape, there is a concern that the splicing tape adhered to the carrier tape is peeled off by an adhesive force between the splicing tape and the protective tape if the carrier tape is cautiously lifted up by an operator.

An object of the invention is to provide a splicing device which automatically connects two carrier tapes, and accurately takes out a carrier tape in which splicing has been completed from the inside of a device.

### Solution to Problem

In order to achieve the above-described object, the invention related to claim 1 is directed to a splicing device which connects a first carrier tape and a second carrier tape that are provided with feeding holes and component accommodation cavities at a constant interval to each other by a splicing tape, the device including: a device main body; a lid which is supported to be opened and closed with respect to the device main body; a positioning device which feeds the first and the second carrier tapes in a direction of approaching each other, and positions the first and the second carrier tapes to a splicing position, between the device main body and the lid; a splicing tape which is pasted to a protective tape fed in a direction which is orthogonal to feeding direction of the first and the second carrier tapes, and positioned at the splicing position, between the device main body and the lid; a bonding device which bonds the splicing tape fed to the splicing position to straddle the first and the second carrier tapes; and a lifting-up device which lifts up the first and the second carrier tapes bonded by the splicing tape, and peels off the splicing tape from the protective tape.

According to the invention related to claim 1, since it is always possible to lift up the carrier tape in which the splicing has been completed in a constant state by the lifting-up device, the splicing tape which is adhered to the carrier tape is not peeled off. Therefore, it is possible to more reliably and easily take out the carrier tape in which the splicing has been completed from the inside of the device.

The invention related to claim 2 is directed to the splicing device according to claim 1, in which the lifting-up device is provided in the lid, and lifts up the first and the second carrier tapes being interlocked with opening of the lid.

According to the invention related to claim 2, as the lifting-up device is provided in the lid which can be opened and closed, it is possible to operate the lifting-up device in conjunction with the opening of the lid, and to simply configure the lifting-up device.

The invention related to claim 3 is directed to the splicing device according to claim 1 or 2, in which the device further includes: a closed-state holding device which holds the lid in a closed state; and an opening operation device which operates the lid in an opening direction when the closed-state holding device is released.

According to the invention related to claim 3, since the lid is held in a closed state by a closed-state holding device if the lid is closed, it is possible to prevent the operator from coming into contact with the operation portion in the device during the operation, and thus, to ensure safety. In addition, since the lid can be opened by the opening operation device when the splicing has been completed, it is possible to easily and rapidly take out the carrier tape in which the splicing has been completed.

The invention related to claim 4 is directed to the splicing device according to any one of claims 1 to 3, in which the lifting-up device includes one pair of hooks that lift up the carrier tapes on both sides of the splicing tape.

According to the invention related to claim 4, since carrier tapes which are connected by the splicing tape can be lifted at two points (a first carrier tape side and a second carrier tape side) by one pair of hooks, it is possible to more stably peel off the splicing tape from the protective tape.

The invention related to claim 5 is directed to the splicing device according to claim 4, in which the one pair of hooks have a receiving portion provided with an inclination that lifts up the carrier tape from one end side of the carrier tape in a width direction.

According to the invention related to claim 5, since the splicing tape can be gradually peeled off from one end side of the protective tape in the width direction thereof by the receiving portion provided with the inclination, it is possible to smoothly peel off the splicing tape from the protective tape .

The invention related to claim 6 is directed to the splicing device according to any one of claims 1 to 5, in which the device further includes: a blocking device which blocks the protective tape from floating up when the carrier tape is lifted up by the lifting-up device.

According to the invention related to claim 6, it is possible to prevent the protective tape from floating up when lifting up the carrier tape by the lifting-up device by using a blocking device, and to more reliably peel off the splicing tape from the protective tape.

### Brief Description of Drawings

[Fig. 1] Fig. 1 is a view illustrating a tape feeder which is appropriate for carrying out the invention.
[Fig. 2] Fig. 2 is a view illustrating a carrier tape which is held by the tape feeder.
[Fig. 3] Fig. 3 is a sectional view cut along line 3-3 of Fig. 2.
[Fig. 4] Fig. 4 is a plan view of the carrier tape which is connected by a splicing device.
[Fig. 5] Fig. 5 is a perspective view of the entire splicing device illustrating an embodiment of the invention.
[Fig. 6] Fig. 6 is a view illustrating a state where a lid of the splicing device is opened.
[Fig. 7] Fig. 7 is a view illustrating a state where a splicing tape is mounted on the splicing device.
[Fig. 8] Fig. 8 is a view illustrating a supply reel around which the splicing tape used in the splicing device is wound.
[Fig. 9] Fig. 9 is a view illustrating a state where the splicing tape is pasted to a protective tape.
[Fig. 10] Fig. 10 is a view illustrating a protective tape feeding device which feeds the protective tape.
[Fig. 11] Fig. 11 is a view illustrating a state where a device main body and the lid of the splicing device are detached and the inside of the device is exposed.
[Fig. 12] Fig. 12 is a view illustrating a schematic configuration of the splicing device.
[Fig. 13] Fig. 13 is a view of an operating state of Fig. 12 illustrating a process of positioning a cut location of the carrier tape.
[Fig. 14] Fig. 14 is a view of an operating state of Fig. 12 illustrating a process of cutting the cut location of the carrier tape.

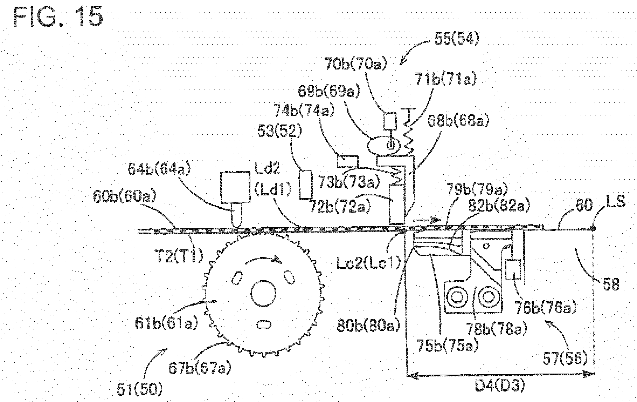

[Fig. 15] Fig. 15 is a view of the operating state of Fig. 12 illustrating a process of positioning a splicing position of the carrier tape.
[Fig. 16] Fig. 16 is a perspective view illustrating a bonding device of the splicing device.
[Fig. 17] Fig. 17 is a plan view illustrating the bonding device.
[Fig. 18] Fig. 18 is a front view when viewed from a direction of an arrow 18 of Fig. 17.
[Fig. 19] Fig. 19 is a right side view when viewed from a direction of an arrow 19 of Fig. 17.
[Fig. 20] Fig. 20 is a left side view when viewed from a direction of an arrow 20 of Fig. 17.
[Fig. 21] Fig. 21 is a view illustrating a closed-state holding device which holds the lid to be closed.
[Fig. 22] Fig. 22 is a view illustrating a lifting-up device provided in the lid.
[Fig. 23] Fig. 23 is a view illustrating a lifting-up arm of the lifting-up device when viewed from a direction of an arrow 23 of Fig. 22.
[Fig. 24] Fig. 24 is a sectional view illustrating a relationship between the carrier tape and the splicing tape at the splicing position.
[Fig. 25] Fig. 25(A) is a sectional view cut along line 25-25 of Fig. 24, and Figs. 25(B) and 25(C) are views illustrating an operating state of Fig. 25(A).

### Description of Embodiments

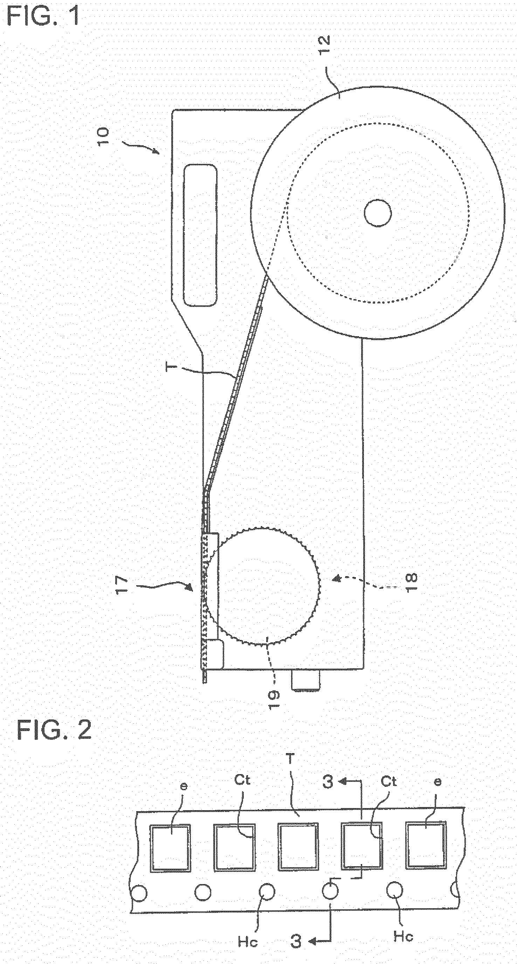

Hereinafter, an embodiment of the invention will be described based on the drawings. Fig. 1 illustrates a tape feeder 10 which is attachably and detachably mounted to a component supply device of a component mounting machine. A reel 12 around which a carrier tape T is wound is attached to the tape feeder 10 being attachable and detachable.

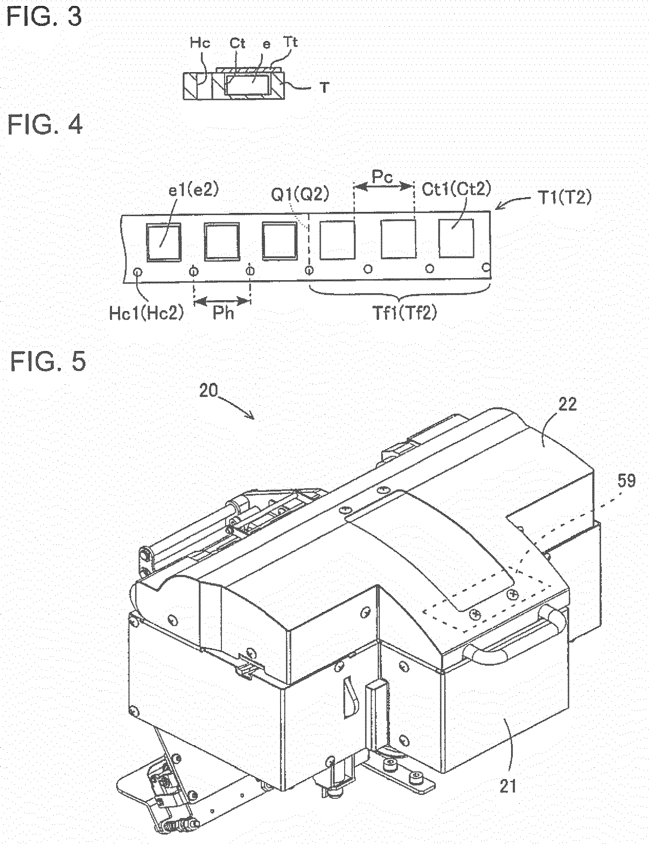

As illustrated in Figs. 2 and 3, the carrier tape T is formed to be elongated with a predetermined width, multiple cavities Ct are installed at a constant pitch interval in a longitudinal direction, and components (electronic components) e mounted on a circuit board are respectively accommodated in the cavities Ct. Upper portions of the cavities Ct are opened, and are covered with a top tape Tt which is pasted to a surface of the carrier tape T.

On one end side of the carrier tape T in the width direction, feeding holes Hc are formed at a pitch interval which is the same as that of the cavities Ct, or at a pitch interval which is two times that of the cavities Ct, and the feeding holes Hc are disposed having a constant positional relationship with the cavities Ct.

In the tape feeder 10, a fixed amount feeding mechanism 18 which feeds out the carrier tape T wound around the reel 12 by a fixed amount, and supplies the electronic components e one by one to a component supply position 17 provided in a tip end portion of the tape feeder 10, is embedded. The fixed amount feeding mechanism 18 is supported to be rotatable by a main body of the tape feeder 10, and is provided with a sprocket 19 which is engaged with the feeding holes Hc of the carrier tape T and a motor which is not illustrated and rotates the sprocket 19 by one pitch.

In addition, the carrier tape T which is used in the component mounting machine is configured of plural types in which the pitches of the cavities Ct are different from each other, and the pitch interval of the cavities Ct and the relationship between the cavities Ct and the feeding holes Hc are determined according to the type of the carrier tape T. Therefore, by recognizing the pitch interval of the cavities Ct by image processing or the like, it is possible to grasp which type of the carrier tape T is used, and based on this, it is possible to recognize the position of the feeding hole Hc of the carrier tape T, and to determine the cut position of the carrier tape T when performing the splicing which will be described later.

A splicing device 20 is a device which automatically connects a trailer of the carrier tape wound around a current reel that is mounted on the tape feeder 10 mounted on the component supply device, to a leader of the carrier tape wound around the next reel to be replaced.

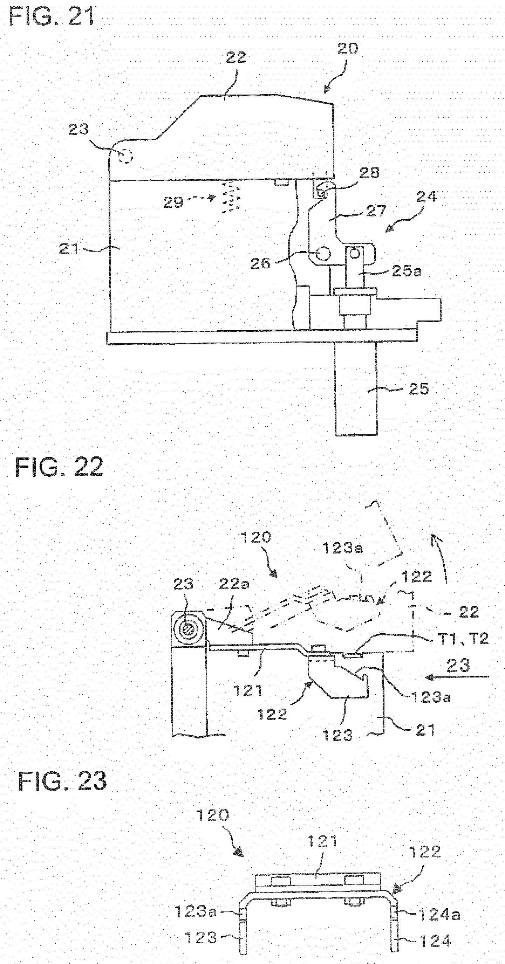

As illustrated in Fig. 5, the splicing device 20 is provided with a box-shaped device main body 21, and a lid 22 which is supported to be rotatable around a pivot 23 (refer to Fig. 21) by the device main body 21, and opens and closes an upper surface of the device main body 21. The splicing device 20 is configured to be loaded on a wheeled table or the like which is not illustrated and to be movable between the tape feeders 10 which are mounted on the component supply device of the component mounting machine. The lid 22 is manually closed when the splicing is performed, and is automatically opened when the carrier tape T is taken out after the splicing. In addition, once the lid 22 is closed, the closed state is held by a closed-state holding device which will be described later.

As illustrated in Fig. 4, in the two carrier tapes T (hereinafter, a first carrier tape T1 and a second carrier tape T2) which are spliced by the splicing device 20, first cavities Ct1 (second cavities Ct2) in which the same type of first components e1 (second components e2) are stored, are provided at a predetermined pitch Pc.

In addition, on the first and the second carrier tapes T1 and T2, first feeding holes Hc1 (second feeding holes Hc2) which can be meshed with teeth 67a (67b) of a first sprocket 61a (second sprocket 61b) of a first tape feeding device 50 (second tape feeding device 51) which will be described later are punched at a predetermined pitch Ph corresponding to the first cavities Ct1 (second cavities Ct2).

The first and the second carrier tapes T1 and T2 cut arbitrary first and second cut locations Q1 and Q2 by the splicing device 20 and makes the first and the second cut locations Q1 and Q2 abut against each other, and connects the first and the second cut locations Q1 and Q2 to each other by a splicing tape 30 which will be described later. As the first cut location Q1 (second cut location Q2), for example, an intermediate position between the first cavity Ct1 (second cavity Ct2) having the first component e1 (second component e2) and the empty first cavity Ct1 (second cavity Ct2) which does not have the first component e1 (second component e2) is selected.

The first carrier tape T1 (second carrier tape T2) on which the empty first cavities Ct1 (second cavities Ct2) are in a row after the cut portion is disposed of as a first unnecessary part Tf1 (second unnecessary part Tf2). In addition, in order to leave an arbitrary number of empty first cavities Ct1 (second cavities Ct2), the intermediate position of the empty first cavities Ct1 (second cavities Ct2) which are adjacent to each other can be selected as the first cut location Q1 (second cut location Q2).

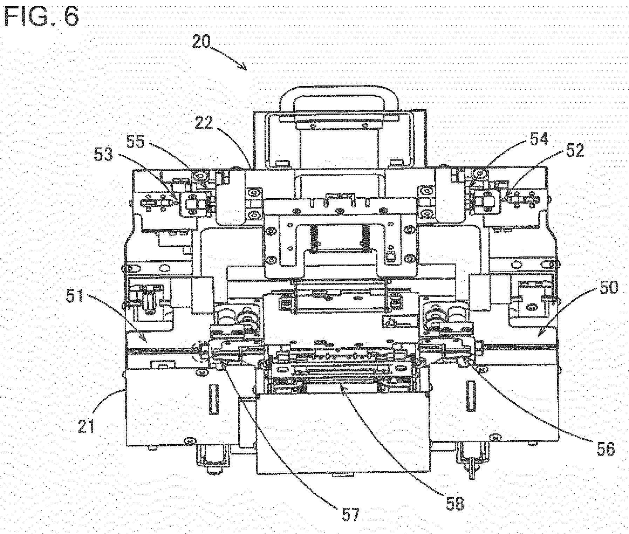

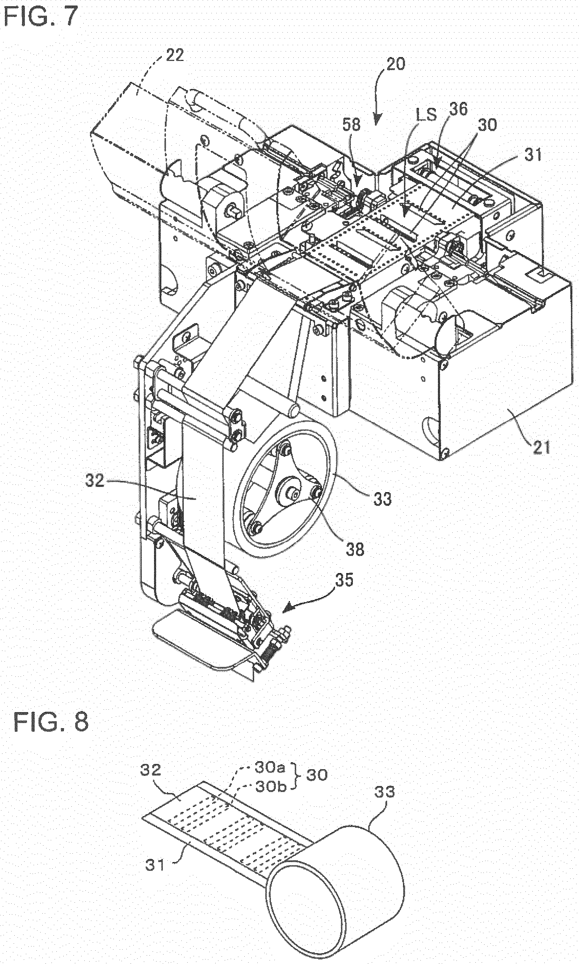

The two carrier tapes T1 and T2 to be spliced are sent into the splicing device 20 in a horizontal direction of Fig. 6, and at the same time, a protective tape 31 (refer to Fig. 7) which pastes the splicing tape 30 that connects the two carrier tapes T1 and T2 in a direction from the above in Fig. 6 which is orthogonal to the horizontal direction is sent into the splicing device 20. In addition, as illustrated in Fig. 7, at a splicing position LS at which the carrier tapes T1 and T2 and the protective tape 31 intersect with each other, both end portions of the two carrier tapes T1 and T2 are connected to each other by the splicing tape 30.

In addition, the splicing tape 30 which is pasted to the protective tape 31 is sent to the splicing position LS by considering an adhered surface between the carrier tapes T1 and T2 as an upper side, and the two carrier tapes T1 and T2 are positioned above the splicing tape 30.

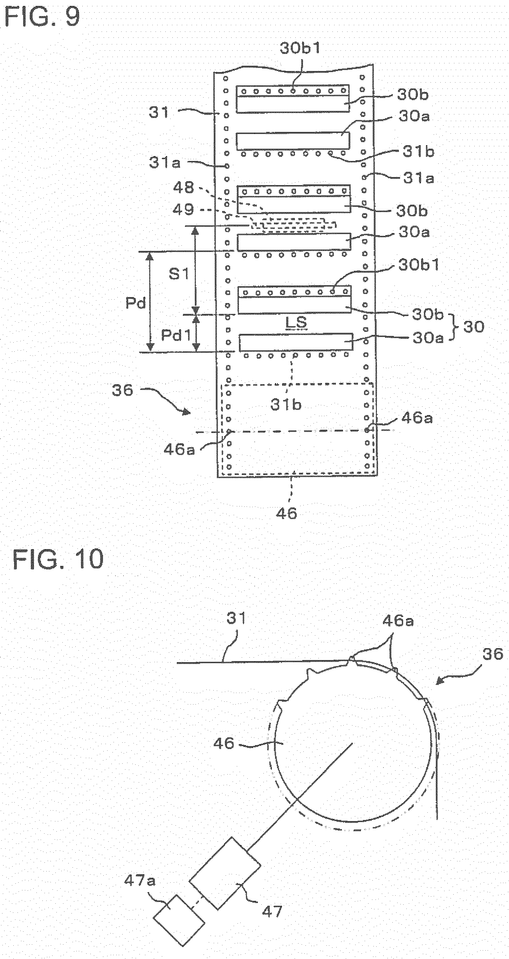

As illustrated in Figs. 8 and 9, the splicing tape 30 is configured of one set of splicing tapes 30a and 30b for a front surface and a rear surface, which straddle the two carrier tapes T1 and T2, and are adhered to the both surfaces of the two carrier tapes T1 and T2, on the upper surface of the continuous protective tape 31. In other words, the splicing tape 30 is configured of one set of the splicing tape 30a for the front surface which is bonded to the front surface side of the two carrier tapes T1 and T2, and the splicing tape 30b for the rear surface which is bonded to the rear surface side of the two carrier tapes T1 and T2.

The one set of splicing tapes 30 for the front surface and the rear surface, are pasted at a constant pitch interval Pd in the longitudinal direction of the protective tape 31 while holding a constant positional relationship with feeding holes 31a which are punched at a constant pitch interval on both sides of the protective tape 31. In addition, the one set of splicing tapes 30a and 30b are disposed at a predetermined interval Pd1 by considering the splicing tape 30a for the front surface as a preceding side. In addition, in the one set of the splicing tapes 30a and 30b, metal powder is buried, and the splicing tapes 30a and 30b can be detected by a tape detection sensor which can detect metal and which will be described later.

As illustrated in Fig. 9, below the protective tape 31, a tape detection sensor 48 which detects the splicing tapes 30a and 30b is installed at a position which is separated from the splicing position LS only by a certain distance S1, on a near side of the splicing position LS. When an end portion of the splicing tape 30 (for example, the splicing tape 30b for the rear surface) is detected through a detecting slit 49 by the metal detection sensor 48, as the protective tape 31 is controlled to be fed from the detection position only by the certain amount S1 by a stepping motor 47 of a protective tape feeding device 36, the splicing tape 30 is positioned to the splicing position LS.

The upper surfaces of the splicing tapes 30a and 30b form affixing surfaces which straddle the two carrier tapes T1 and T2 and are adhered to both surfaces, and as illustrated in Fig. 8, a continuous paper mount 32 is adhered to the adhering surface, and a three-layered structure including the paper mount 32, the splicing tape 30, and the protective tape 31 is wound around a supply reel 33 in a rolled shape.

Dimensions of the protective tape 31 in a width direction are greater than dimensions of the paper mount 32 in a width direction, and both ends of the protective tape 31 in the width direction protrude more than both ends of the paper mount 32 in the width direction. Meanwhile, dimensions of the splicing tape 30 in the width direction are equivalent to the dimensions of the paper mount 32 in the width direction, and the splicing tape 30 is pasted to the protective tape 31 as one set for the front surface and the rear surface on the inside of the feeding hole 31a.

As illustrated in Fig. 9, on the protective tape 31, a plurality of positioning holes 31b are formed along the width direction of the protective tape 31 at the same pitch interval as that of the feeding holes Hc1 and Hc2 which are formed on the carrier tapes T1 and T2, at a position which is close to the splicing tape 30a for the front surface. In addition, on the splicing tape 30b for the rear surface, a plurality of positioning holes 30b1 are formed along the width direction of the protective tape 31 passing through the protective tape 31 at the same pitch interval as that of the feeding holes Hc1 and Hc2 which are formed on the carrier tapes T1 and T2.

In addition, the feeding hole 31a and the positioning hole 31b which are formed on the protective tape 31 are formed by punching press or the like in accordance with the formation of the positioning hole 30b1 on the splicing tape 30b after the splicing tapes 30a and 30b are pasted to a predetermined position on the protective tape 31.

As illustrated in Fig. 7, in the splicing device 20, on a line which crosses the splicing position LS that splices the two carrier tapes T1 and T2, a rotatable supply reel 33 around which the three-layered structure including the splicing tape 30 is wound in a rolled shape, a paper mount feeding device 35 which feeds out the paper mount 32 peeled off from the splicing tape 30, and a protective tape feeding device 36 which feeds out the protective tape 31 from which the splicing tape 30 is peeled off, are installed.

An adhesive force between the paper mount 32 and the protective tape 31 which are adhered to both surfaces of the splicing tape 30 is stronger with respect to the protective tape 31 side, and even when the paper mount 32 is peeled off from the splicing tape 30, the splicing tape 30 is not peeled off from the protective tape 31.

However, when the carrier tapes T1 and T2 are adhered to the adhering surface of the splicing tape 30 on which the paper mount 32 is peeled off, the adhesive force is stronger with respect to the protective tape 31 side, and the protective tape 31 is likely to be peeled off from the splicing tape 30.

In a state of being wound around the supply reel 33, the three-layered structure including the paper mount 32, the splicing tape 30, and the protective tape 31, is mounted on the splicing device 20, and the tip end thereof is pulled out from the supply reel 33. In addition, the paper mount 32 is peeled off and folded back by the operator, and the paper mount 32 is fed out by the paper mount feeding device 35, and is disposed of to a paper mount accommodation box which is not illustrated.

The supply reel 33 is supported to be rotatable by a supporting body 38 which is attached to the device main body 21. The supporting body 38 is pressed to the supply reel 33 by a predetermined friction force caused by a spring force, and the rotation of the supply reel 33 with respect to the supporting body 38 is restricted by the supporting body 38. In addition, when the protective tape 31 is pulled by an operating force which exceeds the friction force, rotation of the supply reel 33 with respect to the supporting body 38 is possible.

The protective tape 31 from which the paper mount 32 is peeled off, that is, the multiple pasted protective tapes 31 by considering the splicing tape 30 as the adhering surface which is an upper side, makes the tip end portion engaged with a feeding sprocket 46 (refer to Fig. 10) in the protective tape feeding device 36 through a bonding device 58, which will be described later, by crossing the center of the splicing position LS.

As illustrated in Fig. 10, in the feeding sprocket 46, a plurality of engagement teeth 46a are formed at an equivalent angle interval in a circumferential direction at the same pitch as the pitch of the feeding holes 31a punched on the protective tape 31, and as the stepping motor 47 which is linked to the feeding sprocket 46 is driven at one pitch, the protective tape 31 which is engaged with the engagement teeth 46a is fed out by a unit volume.

The stepping motor 47 returns to an original point as a power supply is input, and positions the engagement teeth 46a of the feeding sprocket 46 to always be positioned at a top point. In addition, the stepping motor 47 can appropriately restrict the rotation by rotation restriction means 47a, such as a servo lock device.

By the friction action of the above-described supporting body 38 and the rotation restriction means 47a, when the carrier tapes T1 and T2 in which the splicing has been completed are taken out from the inside of the splicing device 20, a blocking device which restricts the movement of both end sides of the protective tape 31 and blocks the protective tape 31 from floating up is configured.

As illustrated in Fig. 6, the splicing device 20 is provided with the first and the second tape feeding devices 50 and 51, first and second component detection devices 52 and 53, first and second cutting devices 54 and 55, first and second taking-in devices 56 and 57, the bonding device 58, and a control device 59 (refer to Fig. 5). The first and the second tape feeding devices 50 and 51, the first and the second cutting devices 54 and 55, the first and the second taking-in devices 56 and 57, the bonding device 58 (excluding one part), and the control device 59 are disposed to be accommodated inside the device main body 21 and the lid 22.

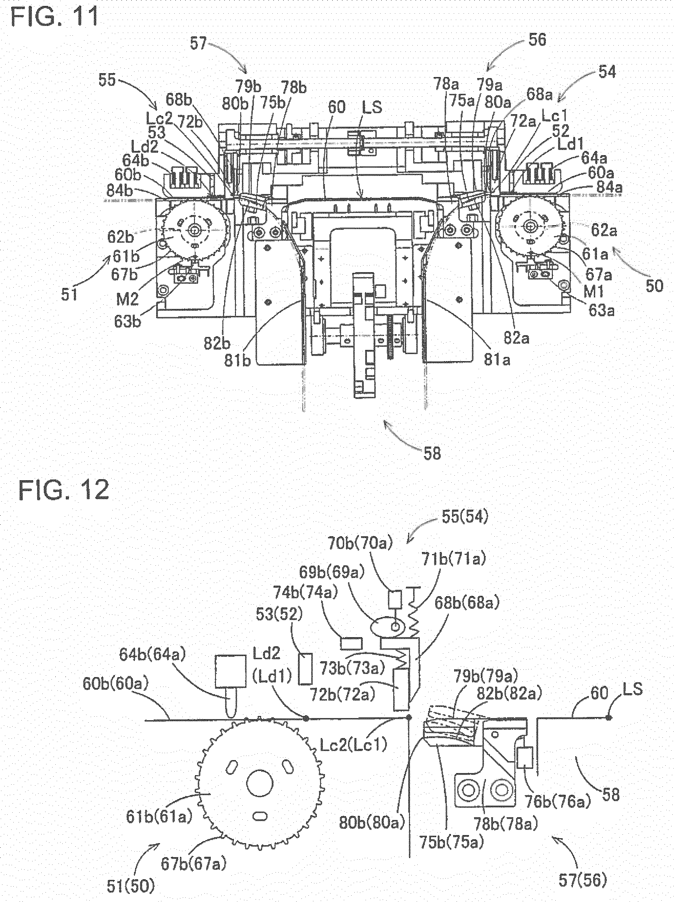

In other words, as illustrated in Fig. 11, the first and the second tape feeding devices 50 and 51 are respectively disposed on both sides in the device main body 21 and the lid 22, and the first and the second cutting devices 54 and 55 are respectively disposed between the first and the second tape feeding devices 50 and 51. Furthermore, the first and the second taking-in devices 56 and 57 are respectively disposed between the first and the second cutting devices 54 and 55, and the bonding device 58 is disposed between the first and the second taking-in devices 56 and 57. In addition, the first and the second component detection devices 52 and 53 are disposed above first and second detected positions Ld1 and Ld2 of first and second transporting paths 60a and 60b of the first and the second tape feeding devices 50 and 51.

The first and the second tape feeding devices 50 and 51 are provided with the first and the second transporting paths 60a and 60b provided to extend in a horizontal direction towards the center from both side surfaces of the device main body 21, the first and the second sprockets 61a and 61b disposed below the first and the second transporting paths 60a and 60b, first and second stepping motors 62a and 62b which are continuously connected to the first and the second sprockets 61a and 61b, first and second sprocket teeth detection devices 63a and 63b which are disposed in the vicinity of the first and the second sprockets 61a and 61b, and first and second tape detection devices 64a and 64b which are disposed above the first and the second transporting paths 60a and 60b and the like.

The first and the second tape feeding devices 50 and 51 are configured to transport the first and the second carrier tapes T1 and T2 along the first and the second transporting paths 60a and 60b, and to be capable of sequentially positioning the first and the second cut locations Q1 and Q2 (refer to Fig. 4) of the first and the second carrier tapes T1 and T2 to first and second cut positions Lc1 and Lc2 and the splicing position LS.

The first and the second transporting paths 60a and 60b have a width which is slightly wider than the width of the first and the second carrier tapes T1 and T2, and are formed in a shape of a groove which extends in a straight line from first and second tape inlets 84a and 84b provided on both side surfaces of the device main body 21 to the first and the second cut positions Lc1 and Lc2 of the first and the second carrier tapes T1 and T2 by first and second cutters 68a and 68b of the first and the second cutting devices 54 and 55.

In the first and the second sprockets 61a and 61b, the plurality of first and second teeth 67a and 67b having the same pitch as the pitch Ph of the first and the second feeding holes Hc1 and Hc2 which are punched on the first and the second carrier tapes T1 and T2 are formed in the circumferential direction. The first and the second sprockets 61a and 61b are disposed below the first and the second transporting paths 60a and 60b to be capable of being meshed with the first and the second feeding holes Hc1 and Hc2 of the first and the second carrier tapes T1 and T2 inserted along the first and the second transporting paths 60a and 60b.

The first and the second sprocket teeth detection devices 63a and 63b detect that the first and the second sprockets 61a and 61b are at an original position by reading out first and second marks M1 and M2 given to the side surfaces of the first and the second sprockets 61a and 61b.

The first and the second tape detection devices 64a and 64b detect that the first and the second carrier tapes T1 and T2 are inserted from the first and the second tape inlets 84a and 84b provided on both side surfaces of the device main body 21.

The first and the second component detection devices 52 and 53 detect the first and the second cavities Ct1 and Ct2 of the first and the second carrier tapes T1 and T2 which are transported on the first and the second transporting paths 60a and 60b, a tape part between the first and the second cavities Ct1 and Ct2, and the first and the second components e1 and e2 in the first and the second cavities Ct1 and Ct2.

As illustrated in Figs. 11 and 12, the first and the second cutting devices 54 and 55 are provided with the first and the second cutters 68a and 68b provided at the first and the second cut positions Lc1 and Lc2, first and second cams 69a and 69b which are slidably connected to the first and the second cutters 68a and 68b, first and second gear motors 70a and 70b which are continuously connected to the first and the second cams 69a and 69b, first and second cutter springs 71a and 71b of which one ends are attached to the first and the second cutters 68a and 68b, and the other ends are attached to the inside of the lid 22, first and second pressing members 72a and 72b which are provided to be adjacent to the first and the second cutters 68a and 68b, first and second pressing springs 73a and 73b of which one ends are attached to the first and the second cutters 68a and 68b, and the other ends are attached to the first and the second pressing members 72a and 72b, and first and second cutter detection devices 74a and 74b which are disposed in the vicinity of the first and the second cutters 68a and 68b and the like.

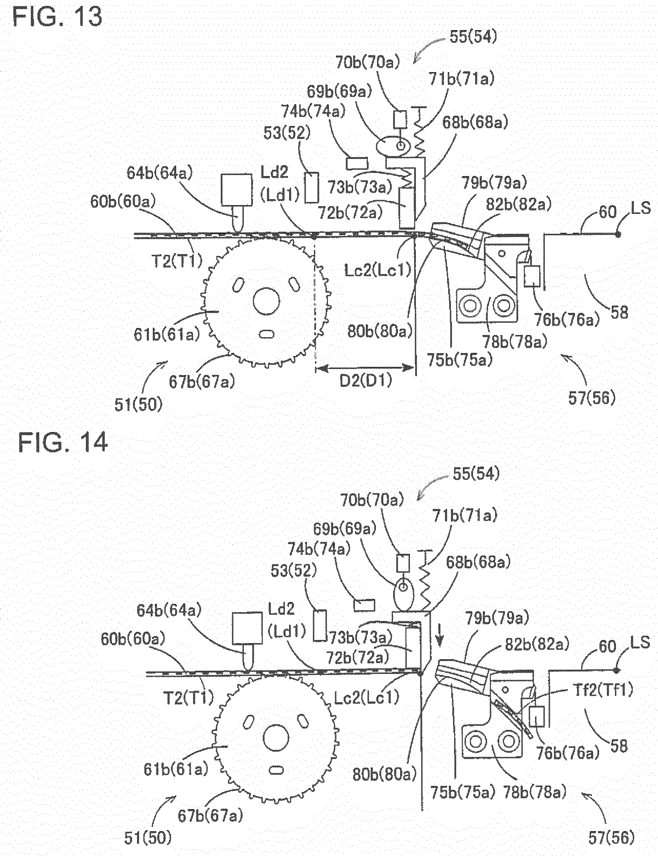

The first and the second cutting devices 54 and 55 are configured to be capable of cutting the first and the second unnecessary parts Tf1 and Tf2 (refer to Fig. 14) at the first and the second cut locations Q1 and Q2 of the first and the second carrier tapes T1 and T2.

The first and the second cutters 68a and 68b are constructed to be movable in the vertical direction, and are vertically moved by the rotation of the first and the second cams 69a and 69b in order to cut the first and the second cut locations Q1 and Q2 of the first and the second carrier tapes T1 and T2 positioned at the first and the second cut positions Lc1 and Lc2.

The first and the second pressing members 72a and 72b are provided to be movable in the vertical direction, and are biased downward by the first and the second pressing springs 73a and 73b in order to press and fix the vicinity of the first and the second cut locations Q1 and Q2 of the first and the second carrier tapes T1 and T2 positioned at the first and the second cut positions Lc1 and Lc2.

The first and the second taking-in devices 56 and 57 are provided between the first and the second cut positions Lc1 and Lc2 and the splicing position LS, and are provided with first and second taking-in members 75a and 75b supported to be rotatable by first and second fixing members 78a and 78b, and first and second taking-in member rotating devices 76a and 76b which rotate the first and the second taking-in members 75a and 75b and the like. The first and the second taking-in devices 56 and 57 are configured to be capable of taking in each of the first and the second unnecessary parts Tf1 and Tf2 cut from the first and the second carrier tapes T1 and T2.

In the first and the second taking-in members 75a and 75b, first and second openings 80a and 80b for taking in the first and the second unnecessary parts Tf1 and Tf2 of the first and the second carrier tapes T1 and T2 transported on the first and the second transporting paths 60a and 60b, and first and second ducts 82a and 82b which guide the first and the second unnecessary parts Tf1 and Tf2 to a disposal location which is not illustrated, are formed.

The first and the second taking-in members 75a and 75b are held at the original position which is illustrated with a one-dot chain line of Fig. 12 when taking in the first and the second unnecessary parts Tf1 and Tf2. In addition, when the first and the second carrier tapes T1 and T2 are transported to the splicing position LS, as illustrated with a solid line of Fig. 12, first and second movable transporting paths 79a and 79b which are rotated by a predetermined angle by the first and the second taking-in member rotating devices 76a and 76b and formed in the first and the second taking-in members 75a and 75b, are aligned in the first and the second transporting paths 60a and 60b.

The bonding device 58 is provided between the first cutting device 54 and the second cutting device 55. The bonding device 58 is configured to be capable of connecting the first and the second carrier tapes T1 and T2 against which the first and the second cut locations Q1 and Q2 abut by the splicing tape 30 at the splicing position LS in the middle of the first and the second transporting paths 60a and 60b.

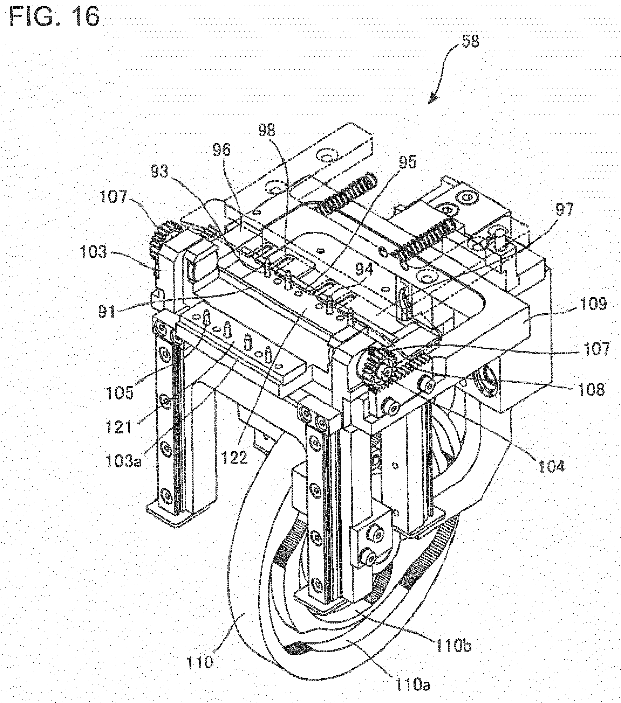

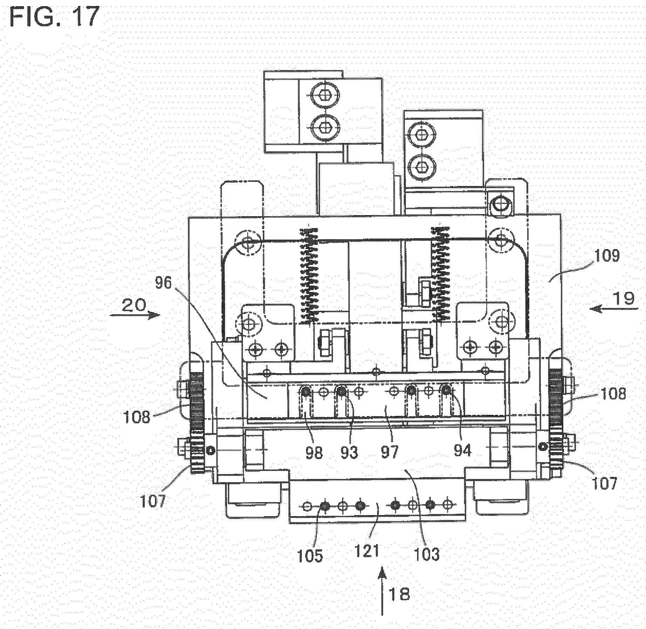

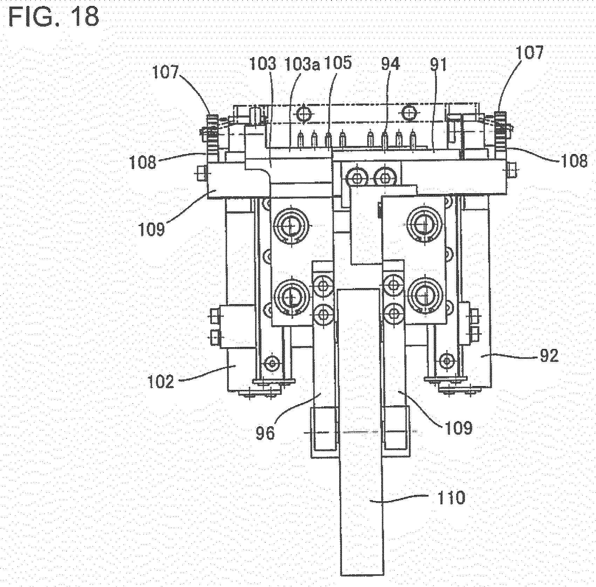

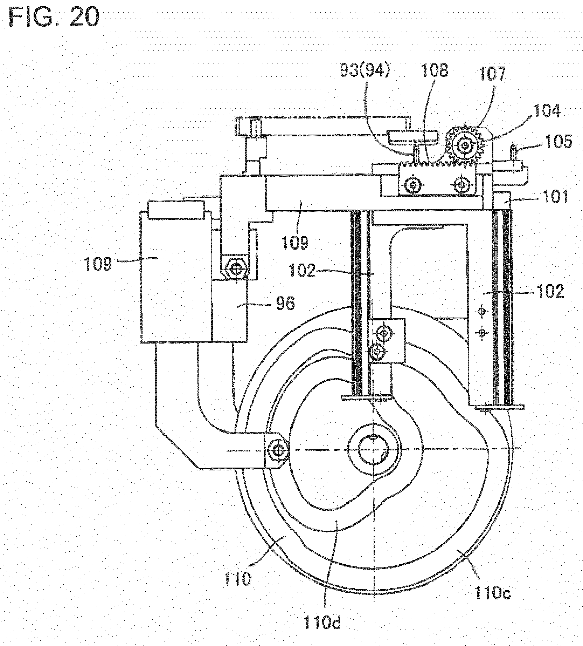

Next, a configuration of the bonding device 58 will be described based on Figs. 16 to 20. The bonding device 58 includes a first lifting and lowering base 91, a presser plate 97, a second lifting and lowering base 101, and a swivel base 103 and the like. The first lifting and lowering base 91 is guided and supported to be capable of raising and lowering a leg 92 thereof to the device main body 21. On the first lifting and lowering base 91, on both sides around a bonding position (abutting position) of the two carrier tapes T1 and T2, two first positioning pins 93 and 94 which can be engaged with the positioning hole 30bl formed on the splicing tape 30b and each feeding hole Hc of the two carrier tapes T1 and T2 respectively protrude along a feeding direction of the carrier tapes T1 and T2. Each pitch of two groups of the first positioning pins 93 and 94 is determined to be two times a pitch Ph of the feeding hole Hc of the carrier tapes T1 and T2.

In addition, on the first lifting and lowering base 91, a pin hole 95 is formed between the first positioning pins 93 and 94, and a second positioning pin 105 on the swivel base 103 side which will be described later can be thrust into the pin holes 95.

A moving platform 96 is guided and supported to be movable in the horizontal direction which is orthogonal to the longitudinal direction of the carrier tapes T1 and T2 in the device main body 21, and the presser plate 97 is attached to the moving platform 96 at a position above the first positioning pins 93 and 94. At a tip end of the presser plate 97, a U-shaped groove 98 which can store the first positioning pins 93 and 94 is formed, and the presser plate 97 can advance or retreat between a retreating end position at which the groove 98 is disengaged from the first positioning pins 93 and 94, and an advancing end position at which the groove 98 stores the first positioning pins 93 and 94.

Furthermore, a leg 102 of the second lifting and lowering base 101 is guided and supported to be capable of being raised and lowered in the device main body 21. On the second lifting and lowering base 101, both ends of the swivel base 103 are supported to be capable of swiveling by 180 degrees around a pivot shaft 104 which is parallel to the longitudinal direction of the carrier tapes T1 and T2. On the swivel base 103, a pressing plate 103a is provided at a position which is offset from the center of swiveling, and the plurality of second positioning pins 105 and pin holes 106 are provided on the pressing plate 103a. The second positioning pins 105 are arranged at positions which correspond to positions between the first positioning pins 93 and 94 provided on the above-described first lifting and lowering base 91, and can be thrust into the pin holes 95 provided on the first lifting and lowering base 91. In addition, the pin holes 106 are arranged at positions which correspond to positions between the second positioning pins 105, and the first positioning pins 93 and 94 provided on the first lifting and lowering base 91 can be thrust therein.

The second positioning pins 105 are engaged with the feeding holes Hc of the two carrier tapes T1 and T2 which are positioned at the splicing position LS and the positioning hole 30b1 of the splicing tape 30b, as the swivel base 103 swivels by 180 degrees, and maintains a constant positional relationship of three members, such as two carrier tapes T1 and T2 and the splicing tape 30 which is connected thereto.

A pinion 107 is attached to the pivot shaft 104 of the swivel base 103, and a rack 108 which is meshed with the pinion 107 is attached to a moving platform 109 which is movable in the horizontal direction which is orthogonal to the transporting direction of the carrier tapes T1 and T2. Accordingly, when the moving platform 109 is moved, the swivel base 103 swivels by a rack and pinion mechanism which is made of the pinion 107 and the rack 108.

As the swivel base 103 swivels, between the pressing plate 103a and the first lifting and lowering base 91, three members, such as the two carrier tapes T1 and T2 and the splicing tape 30, are nipped and connected to each other.

In the device main body 21, a cam drum 110 is supported to be rotatable around a shaft line which is parallel to the center of swiveling of the swivel base 103, and is rotated at a low speed in a certain direction by a driving motor which is not illustrated. On both surfaces of the cam drum 110, inner and outer cam grooves 110a, 110b, 110c, and 110d are respectively formed two by two in an endless shape in the circumferential direction.

A first follower roller which is not illustrated and pivotally supported by the leg 92 of the first lifting and lowering base 91 is engaged with the first cam groove 110a. A second follower roller which is not illustrated and pivotally supported by the moving platform 96 linked to the presser plate 97 is engaged with the second cam groove 110b. A third follower roller which is not illustrated and pivotally supported by the leg 102 of the second lifting and lowering base 101 is engaged with the third cam groove 110c. A fourth follower roller which is not illustrated and pivotally supported by a linking member 112 linked to the moving platform 109 is engaged with the fourth cam groove 110d.

Accordingly, when the cam drum 110 rotates, each of the raising and lowering movements of the first and the second lifting and lowering bases 91 and 101, the advancing and retreating movement of the presser plate 97, and the swiveling movement of the swivel base 103 are performed in conjunction with each other via the first to the fourth follower rollers which are respectively engaged with the first to the fourth cam grooves 110a to 110d. By one rotation of the cam drum 110, the first and the second lifting and lowering bases 91 and 101, the presser plate 97, and the swivel base 103 return to the original position.

As illustrated in Fig. 21, in the splicing device 20, a closed-state holding device 24 which holds the lid 22 to be in a closed state during the splicing operation is provided. The closed-state holding device 24 is installed in the device main body 21, and is mainly provided with a solenoid 25 which can operate an operating rod 25a in the vertical direction, a hook 27 which is supported to be rotatable around a supporting shaft 26 by the device main body 21, and rotated by the solenoid 25, and an engagement pin 28 which is provided to protrude downward in the lid 22, and engaged with the hook 27 to be disengageable.

When an opening spring 29 which biases the lid 22 in an opening direction is provided between the device main body 21 and the lid 22, and the engagement of the hook 27 and the engagement pin 28 is released, the lid 22 is automatically opened by the opening spring 29. An opening operation device which operates the lid 22 in the opening direction when the closed-state holding device 24 is released is configured of the opening spring 29.

In addition, although not illustrated, a dog is provided in the lid 22, and a closing confirmation sensor which is operated by the dog is provided in the device main body 21. The closing confirmation sensor is operated by the dog when closing the lid 22, and confirms that the lid 22 is closed based on an ON signal of the closing confirmation sensor.

In addition, when the lid 22 is closed by the operator, and the closing confirmation sensor is turned ON by the dog, based on the ON signal, the operating rod 25a of the solenoid 25 is operated upward of Fig. 21, and the hook 27 is rotated and engaged with the engagement pin 28. Accordingly, the lid 22 is held in the closed state by the closed-state holding device 24.

In addition, when the two carrier tapes T1 and T2 are connected to each other by the splicing tape 30, and the connection completion signal is generated by the control device 59, the operating rod 25a of the solenoid 25 is operated downward of Fig. 21. Accordingly, the hook 27 is rotated, the engagement with the engagement pin 28 is released, and the lid 22 is automatically opened by a biasing force of the opening operation device (opening spring) 29.

On an inner surface (lower surface) of the lid 22, a lifting-up device 120 (refer to Fig. 22) which lifts up the first and the second carrier tapes T1 and T2 that are connected to each other by the splicing tape 30 is integrally provided in conjunction with the opening of the lid 22. By the lifting-up device 120, the splicing tape 30 which is adhered to the protective tape 31 can be accurately peeled off from the protective tape 31.

As illustrated in Figs. 22 and 23, the lifting-up device 120 is provided with a supporting member 121 which is fixed to an attaching portion 22a provided on the inner surface of the lid 22, and a plate-shaped lifting-up arm 122 which extends in the longitudinal direction of the carrier tapes T1 and T2 is fixed to the tip end portion of the supporting member 121. Both ends of the lifting-up arm 122 is folded, and one pair of hooks 123 and 124 having an interval in the longitudinal direction of the carrier tapes T1 and T2 are formed.

In the one pair of hooks 123 and 124, receiving portions 123a and 124a which lift up the first and the second carrier tapes T1 and T2 that are connected to each other by the splicing tape 30 from below at a position which is in the vicinity of both end portions of the protective tape 31 (splicing tape 30) are respectively formed. The receiving portions 123a and 124a of the one pair of hooks 123 and 124 are positioned below an extending line of the transporting paths 60a and 60b of the carrier tapes T1 and T2 as illustrated with a solid line of Fig. 22 when the lid 22 is closed, and are positioned above the extending line of the transporting paths 60a and 60b as illustrated with a two-dot chain line of Fig. 22 when the lid 22 is opened.

Accordingly, when the lid 22 is opened from the closed state, the lifting-up arm 122 is rotated around the pivot 23 integrally with the lid 22, and as the receiving portions 123a and 124a of the one pair of hooks 123 and 124 cross the first and the second carrier tapes T1 and T2 which are connected to each other by the splicing tape 30, the carrier tapes T1 and T2 are hooked to the receiving portions 123a and 124a and lifted up, and the splicing tape 30 is peeled off from the protective tape 31.

At this time, an inclination is provided in the receiving portions 123a and 124a of the one pair of hooks 123 and 124, and according to this, the carrier tapes T1 and T2 are gradually lifted up from a far side in the width direction. For this reason, the splicing tape 30 is gradually stripped from one end (far side) in the width direction. Therefore, when the splicing tape 30 is peeled off from the protective tape 31, it is possible to accurately connect the carrier tapes T1 and T2 to each other by the splicing tape 30 without peeling off the splicing tape 30 from the carrier tapes T1 and T2.

Next, an operation of the splicing device 20 in the above-described embodiment will be described. When a residual amount of the components e held by the first carrier tape T1 which is wound around the reel 12 attached to the tape feeder 10 decreases, splicing processing which connects the leader of the second carrier tape T2 wound around another reel in which the same type of component e is stored to the trailer of the first carrier tape T1 by the splicing tape 30 is performed. The components are replenished by performing the splicing, and the supply of the components from the tape feeder 10 is continuously performed.

In the splicing, it is checked whether or not the carrier tape in which correct components are generally stored is connected, that is, so-called splicing verifying is performed. The splicing verifying reads out a bar code which is pasted to an old reel by a bar code reader, and sends a serial ID of the component stored in the old reel to a management computer. Next, the bar code which is pasted to a new reel is read out by the bar code reader, and the serial ID of the component stored in the new reel is sent to the management computer.

Since the data related to the component is preserved in every serial ID in a data base of the management computer, it is possible to collate whether or not the components stored in the two carrier tapes T1 and T2 are the same type of components by the read-out serial ID. If the type of component is incorrect, a collation error is displayed on an operation panel and notified to the operator, and based on this, the operator performs the splicing again.

When the splicing verifying has been completed, each end portion of the two carrier tapes T1 and T2 is cut. At this time, since an empty cavity part where the components are not accommodated is generally provided by approximately tens of mm in the end portions of each of the carrier tapes T1 and T2, this part is cut by the operator. In this case, as can be apparent from the description later, since a cut surface is not a matching surface of the two carrier tapes T1 and T2, accuracy is particularly not required.

In general, the lid 22 is closed, and in this state, when the power supply is ON by the operator, the control device 59 makes the stepping motors 62a and 62b return to the original positions based on the detection signal from the first and the second sprocket teeth detection devices 63a and 63b. In this state, the control device 59 detects whether or not the tip end portions of the first and the second tapes T2 are inserted from the first and the second tape inlets 84a and 84b based on the detection signal from the first and the second tape detection devices 64a and 64b. When it is detected that the tip end portions of the first and the second tapes T2 are inserted, the stepping motors 62a and 62b are started, the first and the second sprockets 61a and 61b rotate, and moving members 77a and 77b of the first and the second taking-in members 75a and 75b are moved upward.

Next, the control device 59 detects the first cavities Ct1 and Ct2 and the second cavities Ct1 and Ct2 in which the components e1 and e2 of the first and the second tapes T1 and T2 are absent in order based on the detection signal from the first and the second tape detection devices 64a and 64b, and calculates the pitch Pc between the cavities Ct1 and Ct2 based on the detection of the first and the second cavities Ct1 and Ct2.

Next, the control device 59 calculates the cut locations Q1 and Q2 (refer to Fig. 4) of the first and the second tapes T1 and T2 from the pitch Pc between the cavities Ct1 and Ct2, and distances D1 and D2 between the known detected positions Ld1 and Ld2 and the cut positions Lc1 and Lc2. In addition, as illustrated in Fig. 13, the first and the second tapes T1 and T2 are moved by the distances D1 and D2, the unnecessary parts Tf1 and Tf2 are taken into the first and the second taking-in members 75a and 75b, and the cut locations Q1 and Q2 are transported and positioned at the cut positions Lc1 and Lc2.

In this manner, when the transporting and positioning of the first and the second carrier tapes T1 and T2 are completed, the control device 59 lowers each of the cutters 68a and 68b together with the pressing members 72a and 72b, and presses and fixes the vicinity of the cut locations Q1 and Q2 of the first and the second carrier tapes T1 and T2 positioned at the cut positions Lc1 and Lc2 by the pressing members 72a and 72b. Next, the cutters 68a and 68b are respectively lowered, and the cut locations Q1 and Q2 of the first and the second carrier tapes T1 and T2 are respectively cut. The unnecessary parts Tf1 and Tf2 cut from the first and the second carrier tapes T1 and T2 are guided to the ducts 82a and 82b of the taking-in members 75a and 75b and disposed of.

When the first and the second carrier tapes T1 and T2 are cut by the cutters 68a and 68b, the control device 59 moves the taking-in members 75a and 75b downward. Then, the sprockets 61a and 61b respectively rotate by the stepping motors 62a and 62b, respectively move the first and the second carrier tapes T1 and T2 only by known distances D3 and D4 between the cut positions Lc1 and Lc2 and the splicing position LS, and transport and position the cut locations Q1 and Q2 of the first and the second carrier tapes T1 and T2 to the splicing position LS. Accordingly, the feeding holes Hc1 and Hc2 of the first and the second carrier tapes T1 and T2 are positioned at a position where the bonding device 58 provided at the splicing position LS can be engaged with the first positioning pins 93 and 94 of the bonding device 58.

A positioning device which positions the first and the second carrier tapes T1 and T2 to the splicing position LS at which the positioning pins 93 and 94 are engaged with each of the feeding holes Hc1 and Hc2 of the first and the second carrier tapes T1 and T2 by the above-described first and the second tape feeding devices 50 and 51 and the like.

According to this, the tip ends of the first and the second carrier tapes T1 and T2 which are inserted from the first and the second tape inlets 84a and 84b are positioned at the splicing position LS without generating deviation in pitch.

Meanwhile, in the three-layered structure including the paper mount 32 wound around the supply reel 33, the splicing tape 30, and the protective tape 31, the paper mount 32 is pulled out from the supply reel 33, peeled off, and fed out by the paper mount feeding device 35. The protective tape 31 to which the splicing tape 30 is pasted is fed out by the protective tape feeding device 36, and one set of the splicing tapes 30 for the front surface and the rear surface are transported to the splicing position LS.

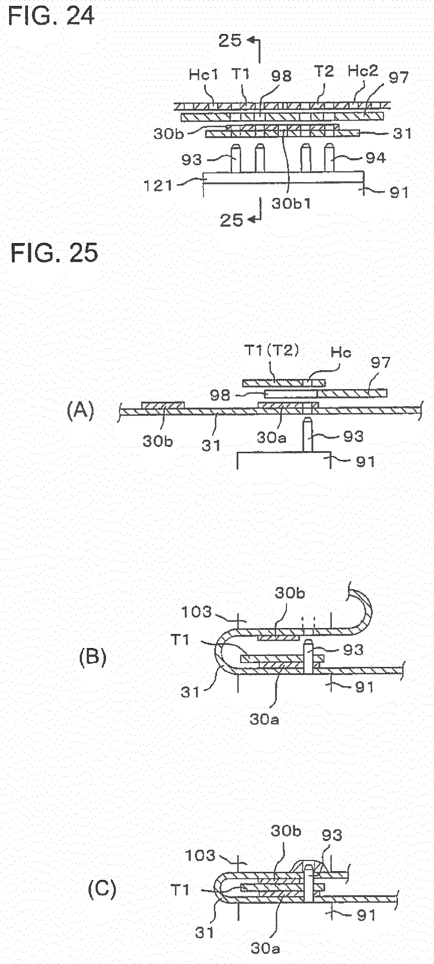

By the stepping motor 47 of the protective tape feeding device 36, the splicing tape 30b for the rear surface is fed to a position which is detected by the tape detection sensor 48, and is further fed by a certain distance from this position. Accordingly, the one set of the splicing tapes 30 for the front surface and the rear surface are fed to the splicing position LS, and the positioning hole 30b1 formed on the splicing tape 30b for the rear surface is positioned at a position where the bonding device 58 provided at the splicing position LS is engaged with the first positioning pins 93 and 94 (refer to Fig. 24).

In addition, when the splicing tape 30 is positioned at the splicing position LS, in a case where the first and the second carrier tapes T1 and T2 are not positioned yet at the splicing position LS, in this state, the state waits until the first and the second carrier tapes T1 and T2 are positioned at the splicing position LS.

When the first and the second carrier tapes T1 and T2 and the splicing tape 30 are respectively positioned at the splicing position LS, the cam drum 110 is rotated by the driving motor which is not illustrated. By the rotation of the cam drum 110, first, the first lifting and lowering base 91 is raised via the first follower roller which is not illustrated and engaged with the first cam groove 110a.

As the first lifting and lowering base 91 is raised, the first positioning pins 93 and 94 are respectively engaged with the positioning hole 30b1 of the splicing tape 30b for the rear surface, and each of the feeding holes Hc of the two carrier tapes T1 and T2. At this time, as illustrated in Fig. 25(A), since the presser plate 97 is interposed between the splicing tape 30b for the rear surface and the carrier tapes T1 and t2, the carrier tapes T1 and T2 are not adhered to the splicing tape 30b for the rear surface. According to this, the positional relationship of the three members, such as the two carrier tapes T1 and T2 and the splicing tape 30b for the rear surface which is adhered to the rear surface thereof, is maintained to be a constant relationship.

Next, the moving platform 96 is moved in the horizontal direction via the second follower roller which is not illustrated and engaged with the second cam groove 110b, the presser plate 97 which is interposed between the splicing tape 30b for the rear surface and the carrier tapes T1 and T2 is retreated with respect to the first lifting and lowering base 91, and the splicing tape 30b for the rear surface and the carrier tapes T1 and T2 can be adhered to each other.

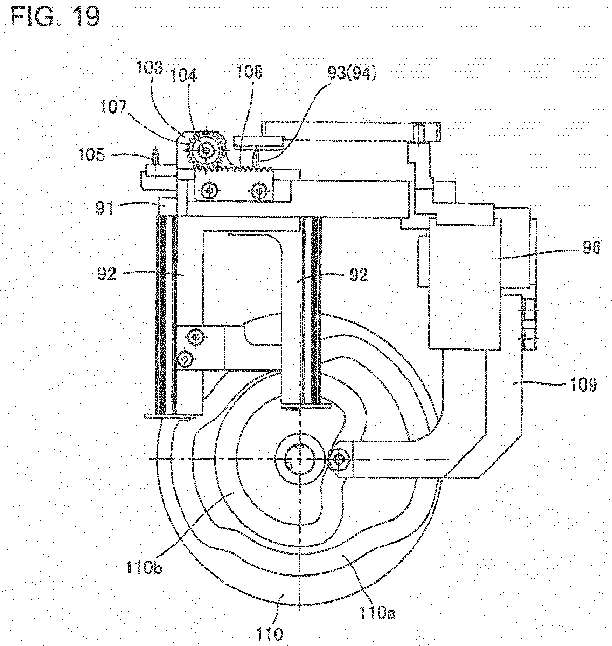

Next, the moving platform 109 is moved horizontally via the third follower roller which is not illustrated and engaged with the third cam groove 110c, and the swivel base 103 swivels clockwise of Fig. 19 by the rack and pinion mechanism (107, 108) as the moving platform 109 moves horizontally. As illustrated in Fig. 25 (B), by the swiveling of the swivel base 103, the protective tape 31 which is engaged with the second positioning pin 105 is folded, and the splicing tape 30a for the front surface is inverted by setting the adhesive surface downward at upper positions of the carrier tapes T1 and T2. In other words, the protective tape 31 is folded to nip the carrier tapes T1 and T2, the splicing tape 30b for the rear surface is positioned on the rear surface side of the carrier tapes T1 and T2, and the splicing tape 30a for the front surface is positioned on the front surface side of the carrier tapes T1 and T2. At this time, a motor of the protective tape feeding device 36 is rotated in reverse, looseness is given to the protective tape 31, and the protective tape 31 is allowed to be folded.

Next, the second lifting and lowering base 101 is lowered via the fourth follower roller which is not illustrated and engaged with the fourth cam groove 110d. When the second lifting and lowering base 101 is lowered, as illustrated in Fig. 25 (C), the second positioning pin 105 is engaged with the positioning hole 31b of the protective tape 31 from the rear side of the protective tape 31, the feeding hole Hc1 of the carrier tapes T1 and T2, and the positioning hole 30b1 of the splicing tape 30b for the rear surface.

Furthermore, by lowering the second lifting and lowering base 101, in a state where the carrier tapes T1 and T2 are nipped, the folded protective tape 31 is pressed between the pressing plate 103a of the swivel base 103 and the first lifting and lowering base 91. As the pressing is performed, the splicing tape 30b for the rear surface which is pasted to the protective tape 31 is adhered to straddle the rear surface of the carrier tapes T1 and T2, and the splicing tape 30a for the front surface is adhered to straddle each of the top tapes Tt pasted to the front surface of the carrier tapes T1 and T2, and the trailer of the first carrier tape T1 and the leader of the second carrier tape T2 are connected to each other. The pressed state is retained for a certain period of time (for several seconds).

Since the connection of the two carrier tapes T1 and T2 by the splicing tape 30 is performed in a state where relative deviation of the carrier tapes T1 and T2 and the splicing tapes 30a and 30b is restricted by the first and the second positioning pins 93, 94, and 105, it is possible to accurately bond the two carrier tapes T1 and T2 to each other without generating the deviation in pitch.

Bonding of the two carrier tapes T1 and T2 by the above-described splicing tape 30 is achieved by the rotation of the cam drum 110 by substantially 180 degrees, and each of the configuration members return to the original positions by the above-described operation in reverse by the rotation by the remaining 180 degrees.

In other words, first, the second lifting and lowering base 101 is raised, the swivel base 103 is raised with respect to the first lifting and lowering base 91, pressing of the folded protective tape 31 is released, and the second positioning pin 105 is disengaged from the positioning hole 30b1 of the splicing tape 30b for the rear surface and each of the feeding holes Hc of the two carrier tapes T1 and T2.

Next, the swivel base 103 swivels counterclockwise of Fig. 19 via the rack and pinion structure (108, 107), the motor of the protective tape feeding device 36 is rotated normally, and the looseness of the protective tape 31 is eliminated.

After this, the presser plate 97 advances, the first lifting and lowering base 91 is lowered, and the first positioning pins 93 and 94 are disengaged from the positioning hole 30b1 of the splicing tape 30b for the rear surface and each of the feeding holes Hc of the two carrier tapes T1 and T2. Meanwhile, the motor is driven in the paper mount feeding device 35, tension is given to the paper mount 32, the paper mount 32 is peeled off by a necessary amount. In this manner, bonding of the trailer of the first carrier tape T1 and the leader of the second carrier tape T2 has been completed.

In this manner, when the two carrier tapes T1 and T2 are connected to each other by the splicing tape 30, a connection completion signal is generated by the control device 59. Based on the connection completion signal, as the rotation of the stepping motor 47 of the protective tape feeding device 36 is restricted by the rotation restriction means 47a, one end side of the protective tape 31 is prevented from being lifted up, and at the same time, as the rotation of the supply reel 33 is limited by the supporting body 38, the other end side of the protective tape 31 is blocked from being lifted up.

Next, the solenoid 25 of the splicing device 20 is operated, the operating rod 25a is moved downward, and the hook 27 is rotated clockwise of Fig. 21 around the supporting shaft 26. Accordingly, the engagement between the hook 27 and the engagement pin 28 is released, and the lid 22 is rotated around the pivot 23 by the biasing force of the spring 29 and is automatically opened.

At this time, by the receiving portions 123a and 124a of the one pair of hooks 123 and 124 of the lifting-up arm 122 provided in the lid 22, the carrier tapes T1 and T2 which are bonded by the splicing tape 30 are lifted upward, and the splicing tape 30 which is affixed to the protective tape 31 is peeled off from the protective tape 31. In this case, an inclination is provided in the receiving portions 123a and 124a, and the carrier tapes T1 and T2 are lifted up from the one end side (far side) in the width direction by the inclination. For this reason, the splicing tape 30 is gradually peeled off from the end portion with respect to the protective tape 31.

In addition, since the protective tape 31 is blocked from being lifted up by the rotation restriction means 47a and the supporting body 38, when the carrier tapes T1 and T2 are lifted up by the lifting-up arm 122, the protective tape 31 is reliably peeled off from the protective tape 31.

According to this, the splicing tape 30 is accurately peeled off from the protective tape 31, and the splicing tape 30 which connects the carrier tapes T1 and T2 is not peeled off from the carrier tapes T1 and T2.

The carrier tapes T1 and T2 lifted up by the lifting-up arm 122 are easily taken out from the inside of the splicing device 20 by the operator. After this, the reel 12 around which the second carrier tape T2 is wound is set in the tape feeder 10, and the splicing processing has been completed. According to this, the components are replenished to the tape feeder 10, and in the component mounting machine, component mounting work is continuously performed without stopping the machine.

In addition, in order to splice a separate carrier tape, when the lid 22 is closed by the operator, the closing confirmation sensor which is not illustrated is turned ON by the dog which is fixed to the lid 22. Based on the ON signal of the closing confirmation sensor, the solenoid 25 is operated, and the operating rod 25a is moved upward. Accordingly, the hook 27 is rotated counterclockwise of Fig. 21 around the supporting shaft 26, and is engaged with the engagement pin 28 which is fixed to the lid 22. At the same time, an operation confirmation sensor which is not illustrated is turned ON by the dog which is not illustrated and attached to the hook 27. When the closing confirmation sensor and the operation confirmation sensor are turned ON together, an automatic operation of the splicing device 20 is possible.

In this manner, when the lid 22 is closed, since the lid 22 cannot be opened by an external force, it is possible to prevent the operator from coming into contact with an operation portion in the splicing device 20 during the automatic operation, and to ensure safety. In addition, when the splicing work has been completed, since the lid 22 is automatically opened, it is possible to improve operability.

According to the above-described embodiment, since it is always possible to lift up the carrier tapes T1 and T2 in which the splicing has been completed in a constant state by the lifting-up device 120, it is possible to easily take out the carrier tapes T1 and T2 in which the splicing has been completed from the inside of the splicing device 20 without peeling off the splicing tape 30 adhered to the carrier tapes T1 and T2.

In addition, as the lifting-up device 120 is provided in the lid 22 which can be opened and closed, it is possible to operate the lifting-up device 120 in conjunction with the opening of the lid 22, and to make the configuration of the lifting-up device 120 simple.

According to the above-described embodiment, when the lid 22 is closed for splicing the carrier tapes T1 and T2, since the lid 22 is held in the closed state by the closed-state holding device 24, it is possible to prevent the operator from coming into contact with the operation portion in the splicing device 20 during the operation, and to ensure safety. In addition, when the splicing has been completed, since it is possible to automatically open the lid 22 by the opening operation device (opening spring) 29, it is possible to easily and rapidly take out the carrier tapes T1 and T2 in which the splicing has been completed.

According to the above-described embodiment, since it is possible to lift up the carrier tapes T1 and T2 which are connected to each other by the splicing tape 30 at two points (on the first carrier tape side and on the second carrier tape side) by the one pair of hooks 123 and 124 of the lifting-up device 120, it is possible to safely peel off the splicing tape 30 which is connected to the splicing tape 30 from the protective tape 31.

According to the above-described embodiment, since the one pair of hooks 123 and 124 have the receiving portions 123a and 124a provided with the inclination, it is possible to gradually peel off the splicing tape 30 from the one end side in the width direction with respect to the protective tape 31, and to smoothly peel off the splicing tape 30 from the protective tape 31.

According to the above-described embodiment, by the blocking device (the supporting body 38, the rotation restriction means 47a), it is possible to block the protective tape from floating up when the carrier tape is lifted up by the lifting-up device 120, and reliably peel off the splicing tape 30 from the protective tape 31.

In the above-described embodiment, an example in which the lifting-up device 120 is provided in the lid 22, and the first and the second carrier tapes T1 and T2 are lifted up in conjunction with the opening of the lid 22 is described, but for example, the lifting-up device 120 may be provided in the device main body 21 and may be operated separately from the lid 22.

In the above-described embodiment, the three-layered structure including the splicing tape 30, the protective tape 31, and the paper mount 32 is described, but a two-layered structure including the splicing tape 30 and the protective tape 31 without providing the paper mount 32 can be employed.

In the above-described embodiment, an example in which the two carrier tapes T1 and T2 which are made of a paper tape having both the front surface and the rear surface which are planes are spliced is described, but for example, a tape, such as an emboss tape in which cavities protrude to the rear surface side and unevenness is made, can also be spliced.

In addition, the positioning devices (the first and the second tape feeding devices) 50 and 51 which position the first and the second carrier tapes T1 and T2 to the splicing position LS, the protective tape feeding device 36 which feeds the protective tape 31 that pastes the splicing tapes 30a and 30b, and the bonding device 58 which bonds the splicing tapes 30a and 30b to the first and the second carrier tapes T1 and T2 at the splicing position LS and the like, merely illustrate an exemplary configuration which is appropriate for carrying out the invention, and the invention is not limited to the configuration described in the embodiment.

In this manner, the invention can select various embodiments within the range without departing from the main idea of the invention described in the range of patent claims.

### Reference Signs List

20 ... SPLICING DEVICE, 21 ... DEVICE MAIN BODY, 22 ... LID, 24 ... CLOSED-STATE HOLDING DEVICE, 29 ... OPENING OPERATION DEVICE, 30 (30a, 30b) ... SPLICING TAPE, 31 ... PROTECTIVE TAPE, 31a ... FEEDING HOLE, 36 ... PROTECTIVE TAPE FEEDING DEVICE, 38, 47a ... BLOCKING DEVICE (SUPPORTING BODY, ROTATION RESTRICTION MEANS), 46 ... SPROCKET, 47 ... SERVO MOTOR (STEPPING MOTOR), 48 ... TAPE DETECTION SENSOR, 50, 51 ... POSITIONING DEVICE (TAPE FEEDING DEVICE), 58 ... BONDING DEVICE, 93, 94, 105 ... POSITIONING PIN, 120 ... LIFTING-UP DEVICE, 122 ... LIFTING-UP ARM, 123, 124 ... HOOK, 123a, 124b ... RECEIVING PORTION, T1, T2 ... CARRIER TAPE, Hcl, Hc2 ... FEEDING HOLE, Ctl, Ct2 ... CAVITY, LS ... SPLICING POSITION

## Claims

1. A splicing device (20) which is configured to connect a first carrier tape (T1) and a second carrier tape (T2) that are provided with feeding holes (Hc1, Hc2) and component accommodation cavities (Ct1, Ct2) at a constant interval to each other by a splicing tape (30), the device comprising:
a device main body (21);
a lid (22) which is supported to be opened and closed with respect to the device main body (21);
a positioning device (51) which is configured to feed the first and the second carrier tapes (T1, T2) in a direction of approaching each other, and is configured to position the first and the second carrier tapes (T1, T2) to a splicing position (LS), between the device main body (21) and the lid (22);
a splicing tape (30) which is configured to be pasted to a protective tape (31) fed in a direction which is orthogonal to feeding direction of the first and the second carrier tapes (T1, T2), and is configured to be positioned at the splicing position (LS), between the device main body (21) and the lid (22);
a bonding device (58) which is configured to bond the splicing tape (30) fed to the splicing position (LS) to straddle the first and the second carrier tapes (T1, T2); and
a lifting-up device (120) which is configured to lift up the first and the second carrier tapes (T1, T2) bonded by the splicing tape (30), and is configured to peel off the splicing tape (30) from the protective tape (31).

2. The splicing device (20) according to claim 1,
wherein the lifting-up device (120) is provided in the lid (22), and is configured to lift up the first and the second carrier tapes (T1, T2) in conjunction with opening of the lid (22).

3. The splicing device (20) according to claim 1 or 2, further comprising:
a closed-state holding device (24) which is configured to hold the lid (22) in a closed state; and
an opening operation device (29) which is configured to operate the lid (22) in an opening direction when the closed-state holding device (24) is released.

4. The splicing device (20) according to any one of claims 1 to 3,
wherein the lifting-up device (120) includes a lifting-up arm (122) which has one pair of hooks (123, 124) that are configured to lift up the carrier tapes (T1, T2) on both sides of the splicing tape (30).

5. The splicing device (20) according to claim 4,
wherein the one pair of hooks (123, 124) have a receiving portion (123a, 124b) provided with an inclination that is configured to lift up one of the carrier tapes (T1, T2) from one end side of the carrier tape (T1, T2) in a width direction.

6. The splicing device (20) according to any one of claims 1 to 5, further comprising:
a blocking device (47a) which is configured to block the protective tape (31) from floating up when the carrier tape (T1, T2) is lifted up by the lifting-up device (120).

## Patentansprüche

1. Spleiß-Vorrichtung (20), die so eingerichtet ist, dass sie ein erstes Trägerband (T1) und ein zweites Trägerband (T2), die mit Transportlöchern (Hc1, Hc2) und Bauteil-Aufnahmehohlräumen (Ct1, Ct2) in einem konstanten Abstand zueinander versehen sind, mittels eines Spleiß-Bandes (30) verbindet, wobei die Vorrichtung umfasst:
einen Vorrichtungs-Hauptkörper (21);
eine Abdeckung (22), die so gelagert ist, dass sie in Bezug auf den Vorrichtungs-Hauptkörper (21) geöffnet und geschlossen wird;
eine Positionier-Vorrichtung (51), die so eingerichtet ist, dass sie das erste und das zweite Trägerband (T1, T2) in einer Richtung gegenseitiger Annäherung transportiert, und so eingerichtet ist, dass sie das erste und das zweite Trägerband (T1, T2) an einer Spleiß-Position (LS) zwischen dem Vorrichtungs-Hauptkörper (21) und der Abdeckung (22) positioniert;
ein Spleiß-Band (30), das so eingerichtet ist, dass es an einem Schutz-Band (31) angeklebt wird, das in einer Richtung transportiert wird, die rechtwinklig zur der Transportrichtung des ersten und des zweiten Trägerbandes (T1, T2) ist, und so eingerichtet ist, dass es an der Spleiß-Position (LS) zwischen dem Vorrichtungs-Hauptkörper (21) und der Abdeckung (22) positioniert wird;
eine Verklebe-Vorrichtung (58), die so eingerichtet ist, dass sie das an die Spleiß-Position (LS) transportierte Spleiß-Band (30) so verklebt, dass es das erste und das zweite Trägerband (T1, T2) überspannt; sowie
eine Anhebe-Vorrichtung (120), die so eingerichtet ist, dass sie das erste und das zweite Trägerband (T1, T2) anhebt, die mit dem Spleiß-Band (30) verklebt sind, und so eingerichtet ist, dass sie das Spleiß-Band (30) von dem Schutz-Band (31) abzieht.

2. Spleiß-Vorrichtung (20) nach Anspruch 1,
wobei sich die Anhebe-Vorrichtung (120) in der Abdeckung (22) befindet und so eingerichtet ist, dass sie das erste und das zweite Trägerband (T1, T2) in Verbindung mit dem Öffnen der Abdeckung (22) anhebt.

3. Spleiß-Vorrichtung (20) nach Anspruch 1 oder 2, die des Weiteren umfasst:
eine Vorrichtung (24) zum Halten eines geschlossenen Zustandes, die so eingerichtet ist, dass sie die Abdeckung (22) in einem geschlossenen Zustand hält; und
eine Öffnungs-Betätigungsvorrichtung (29), die so eingerichtet ist, dass sie die Abdeckung (22) in einer Öffnungs-Richtung betätigt, wenn die Vorrichtung (24) zum Halten eines geschlossenen Zustandes gelöst wird.

4. Spleiß-Vorrichtung (20) nach einem der Ansprüche 1 bis 3,
wobei die Anhebe-Vorrichtung (120) einen Anhebe-Arm (122) enthält, der ein Paar Haken (123, 124) aufweist, die so eingerichtet sind, dass sie die Trägerbänder (T1, T2) an beiden Seiten des Spleiß-Bandes (30) anheben.

5. Spleiß-Vorrichtung (20) nach Anspruch 4,
wobei die Haken (123, 124) des einen Paars einen Aufnahmeabschnitt (123a, 124b) aufweisen, der mit einer Abschrägung versehen ist, die so eingerichtet ist, dass sie eines der Trägerbänder (T1, T2) von der Seite eines Endes des Trägerbandes (T1, T2) in einer Breitenrichtung anhebt.

6. Spleiß-Vorrichtung (20) nach einem der Ansprüche 1 bis 5, die des Weiteren umfasst:
eine Verhinderungs-Vorrichtung (47a), die so eingerichtet ist, dass sie verhindert, dass das Schutz-Band (31) nach oben treibt, wenn das Trägerband (T1, T2) durch die Anhebe-Vorrichtung (120) angehoben wird.

## Revendications

1. Dispositif d'épissurage (20) configuré pour relier une première bande porteuse (T1) et une seconde bande porteuse (T2) dotées d'orifices d'alimentation (Hc1, Hc2) et de cavités d'accueil de composants (Ct1, Ct2) situés à un intervalle constant les uns par rapport aux autres grâce à une bande d'épissurage (30), le dispositif comprenant :
un corps principal de dispositif (21),
un capot (22) qui est supporté pour être ouvert et fermé par rapport au corps principal de dispositif (21),
un dispositif de positionnement (51) qui est configuré pour délivrer les première et seconde bandes porteuses (T1, T2) dans une direction de rapprochement de l'une avec l'autre, et qui est configuré pour placer les première et seconde bandes porteuses (T1, T2) sur une position d'épissurage (LS) entre le corps principal de dispositif (21) et le capot (22),
une bande d'épissurage (30) qui est configurée pour être collée sur une bande protectrice (31) appliquée dans une direction qui est orthogonale à la direction d'alimentation des première et seconde bandes porteuses (T1, T2), et qui est configurée pour être positionnée au niveau de la position d'épissurage (LS) entre le corps principal de dispositif (21) et le capot (22),
un dispositif de liaison (58) qui est configuré pour relier la bande d'épissurage (30) appliquée à la position d'épissurage (LS) afin de faire se chevaucher les première et seconde bandes porteuses (T1, T2), et
un dispositif de levage (120) qui est configuré pour élever les première et seconde bandes porteuses (T1, T2) reliées grâce à la bande d'épissurage (30) et qui est configuré pour décoller la bande d'épissurage (30) de la bande protectrice (31).

2. Dispositif d'épissurage (20) selon la revendication 1,
dans lequel le dispositif de levage (120) est utilisé dans le capot (22), et il est configuré pour élever les première et seconde bandes porteuses (T1, T2) conjointement avec l'ouverture du capot (22).

3. Dispositif d'épissurage (20) selon la revendication 1 ou la revendication 2, comprenant en outre :
un dispositif de maintien à l'état fermé (24) qui est configuré pour maintenir le capot (22) à l'état fermé, et
un dispositif de manoeuvre d'ouverture (29) qui est configuré pour manoeuvrer le capot (22) dans une direction d'ouverture lorsque le dispositif de maintien à l'état fermé (24) est relâché.

4. Dispositif d'épissurage (20) selon l'une quelconque des revendications 1 à 3,
dans lequel le dispositif de levage (120) inclut un bras de levage (122) qui comporte une paire de crochets (123, 124) qui sont configurés pour élever les bandes porteuses (T1, T2) des deux côtés de la bande d'épissurage (30) .

5. Dispositif d'épissurage (20) selon la revendication 4,
dans lequel la paire de crochets(123, 124) comporte une partie de réception (123a, 124b) prévue pour présenter une inclinaison qui est configurée pour élever l'une des bandes porteuses (T1, T2) depuis une terminaison de la bande porteuse (T1, T2) dans la direction de la largeur.

6. Dispositif d'épissurage (20) selon l'une quelconque des revendications 1 à 5, comprenant en outre :
un dispositif de blocage (47a) qui est configuré pour empêcher la bande protectrice (31) de flotter lorsque la bande porteuse (T1, T2) est élevée par le dispositif de levage (120).
